# EUROPÄISCHE PATENTSCHRIFT

(11) **EP 2 508 054 B1**
(45) Veröffentlichungstag und Bekanntmachung des Hinweises auf die Patenterteilung: **31.12.2014**
(21) Anmeldenummer: 10793146.1
(22) Anmeldetag: 19.11.2010
(51) Int. Cl.: H01L 23/40, H01L 23/367, H01L 23/552, H02M 7/00, H05K 7/20

(54) **LEISTUNGSELEKTRONISCHE BAUGRUPPE UND WECHSELRICHTERANORDNUNG**
POWER ELECTRONICS UNIT AND INVERTER ASSEMBLY
MODULE ÉLECTRONIQUE DE PUISSANCE ET SYSTÈME D'ONDULEUR

(30) Priorität: 04.12.2009 DE 202009016531 U; 14.12.2009 DE 102009058270
(43) Veröffentlichungstag der Anmeldung: 10.10.2012
(73) Patentinhaber: Liebherr-Elektronik GmbH, 88131 Lindau (DE)
(72) Erfinder: BALLMANN, Joachim, 63916 Amorbach (DE); BÜSCHING, Rainer, 88079 Kressbronn (DE); ENGLER, Alfred, 88138 Sigmarszell (DE); ENGSTLER, Jürgen, 88214 Ravensburg (DE); MUNDING, Andreas, 93049 Regensburg (DE); OSVALD, Gaetan, 31450 Baziège (FR); PARK, Heyje, 88131 Lindau (DE)
(74) Vertreter: Laufhütte, Dieter
(86) Internationale Anmeldenummer: PCT/EP2010/007033
(87) Internationale Veröffentlichungsnummer: WO 2011/066906

(56) Entgegenhaltungen:
- EP-A1- 1 909 377
- EP-A2- 2 006 989

## Beschreibung

Die Erfindung betrifft eine leistungselektronische Baugruppe sowie eine Wechselrichteranordnung.

Heutzutage steigt die Notwendigkeit, in zukünftigen Leistungselektronik-Entwicklungen beispielsweise in der Industrie und Luftfahrt den Bauraum und damit auch das Gewicht leistungselektronischer Baugruppen unter gleichzeitiger Erhöhung der Temperaturwechselfestigkeit einzusparen. Die Erfindung bezieht sich auf ein Aufbaukonzept mit einer gezielten Anordnung der Komponenten für Wechselrichter.

Elektronische Wechselrichter werden in zahlreichen Anwendungen benötigt, um Energie zwischen einem Gleichstromkreis und mehrphasigen Drehstromsystemen umzuwandeln. Die Anwendung des elektronischen Wechselrichters umfaßt die Steuerung von elektrischen Maschinen zur Fortbewegung und in Stellwerken der Leistungsklasse bis ca. 50 kW, sowohl im Motorbetrieb als auch zur Gewinnung von elektrischer Energie aus Bewegungsenergie (im Folgenden "Generatorbetrieb" genannt). Diese Antriebe und Stellwerke sind wesentliche Bestandteile von z.B. elektrischen Traktionssystemen in der Fahrzeugtechnik, Klappensteuerungen in Klimasystemen der Luftfahrt- und Bahntechnik, Aktuatorsystemen für Flugzeugklappen, Seilwinden in Mobilkränen, usw.

Elektronische Wechselrichter bestehen aus zu Modulen zusammengefaßten elektronischen Leistungsschaltern, die meistens als Halbleiter ausgebildet sind (im folgenden "Leistungsmodule" genannt), Kondensatoren, passiven Filterkomponenten, elektrischen Verbindungen, gelöteten, geschweißten, eingepressten oder gesteckten elektrischen Kontakten, Gehäusen, Kühlelementen, einer Ansteuerschaltung für die Leistungsmodule (im folgenden "Treiberschaltung" genannt), sowie einer Steuerelektronik (im folgenden "Controller" genannt).

Diese Bestandteile des Wechselrichters müssen über geeignete Verbindungselemente elektrisch, mechanisch und thermisch miteinander verbunden werden.

In US 2008/0049476 A1 ist bereits ein Wechselrichter für ein Hybridfahrzeug beschrieben. Unter anderem wird dort eine Halteplatte eingesetzt, um den auf einer Leiterplatte aufgebauten Controller zu fixieren und Wärme von dem Controller oberhalb der Platte sowie den Kondensatoren unterhalb der Platte an das Gehäuse abzuführen. Das Gehäuse enthält einen kühlwasserdurchflossenen Kanal. Die obere Öffnung des Gehäuses ist mit einem metallenen Deckel abgedeckt. Die Treiberschaltung liegt ebenfalls unterhalb der Halteplatte und unmittelbar über den Leistungsmodulen im Gehäuse.

Die US 2003/0132040 A1 offenbart ein Antriebsmodul mit verbesserter Kühlung. In dieser Erfindung befinden sich die Leistungsmodule sowie zumindest die Treiberschaltung auf derselben Seite einer von einem Kühlmittel durchflossenen Wärmesenke, die gleichfalls zur verbesserten elektromagnetischen Schirmung dient. Der Controller kann auf einer Gehäuse-Abdeckung montiert sein, die eine elektromagnetische Abschirmung von Leistungsmodulen und Treiberschaltung herstellt. In der US 2004/0066643 wird auch ein Antriebsmodul mit elektromagnetischer Schirmung über einer Wärmesenke, darauf montiertem Leistungsmodulen, Kondensatoren und Filterelementen mit metallischen Seitenwänden, ferner einem metallischem Deckel und darauf montiertem Controller beschrieben.

Die US 2006/0064998 A1 und die US 2004/0066643 A1 beschreiben eine mit einem Motor verbundene Inverterschaltung, in der Leistungsmodule, Kondensatoren und Steuerschaltungen für die Inverterschaltung über sogenannte Busstiften (Busbars) verbunden sind, die in einer Harzplätte vergossen sind. Weiterhin wird beschrieben, wie eine metallische Schirmplatte zwischen Leistungsmodule einerseits und Treiberschaltung sowie Schutzschaltung andererseits angeordnet ist. In einer alternativen Ausführung werden Treiberschaltung und Controller kombiniert unterhalb der Schirmplatte eingelegt.

Die EP 1 909 377 A1 offenbart eine Leistungselektronik zur Steuerung eines Motors für ein Klimagerät. Leistungskomponenten und Steuerungskomponenten werden auf separaten Platinen angeordnet. Die Wärmeabfuhr erfolgt durch ein passives Kühlelement, das thermisch mit dem Leistungsmodul gekoppelt ist.

Die EP 2 006 989 A2 zeigt einen Leistungskonverter, dessen Leistungsmodul innerhalb einer Kühlkammer angeordnet ist.

Im Stand der Technik werden die Treiberschaltung und der Controller deshalb nicht oberhalb einer Schirm- und/oder Kühlplatte kombiniert, weil einerseits die elektrischen Verbindungen zwischen Leistungsmodulen, Kondensatoren und Batterie eine gewisse Bauhöhe benötigen und andererseits weil die Verbindung zwischen Treiberschaltung und Leistungsmodulen so kurz wie möglich sein sollten. Erst durch eine vertikale Anordnung der elektrischen Verbindungen zwischen Leistungsmodulen und Kondensatoren und/oder Leistungsmodulen und Batterie können Treiberschaltung und Controller gemeinsam auf einem elektromagnetisch schirmenden und thermisch leitfähigen Element angeordnet werden.

Aufgabe der vorliegenden Erfindung ist es, eine leistungselektronische Baugruppe sowie eine Wechselrichteranordnung zu schaffen, die einfach und kompakt sind und bei hohen Umgebungstemperaturen und großen Temperaturwechseln eine hohe Zuverlässigkeit vorweisen.

Zur Lösung der Aufgabe wird eine leistungselektronische Baugruppe nach Anspruch 1 mit mindestens einer Treiberschaltung, mindestens einem Controller, einer Wärmesenke sowie Stromleitungen angegeben, wobei die Treiberschaltung und der Controller auf der Oberseite der Wärmesenke und die Stromleitungen auf der Unterseite der Wärmesenke angeordnet sind. Die leistungselektronische Baugruppe weist somit erfindungsgemäß einen Sandwich-Aufbau auf.

Weiterhin wird diese Aufgabe durch eine Anordnung eines Wechselrichters nach Anspruch 17 mit einem Gehäuse oder Gehäuseteil, einem Wasserkühler, mindestens einem Leistungsmodul, mindestens einem Kondensator, sowie der erfindungsgemäßen Baugruppe im Sandwich-Aufbau gelöst, wobei sich der Kondensator in derselben Ebene wie das Leistungsmodul befindet, und sich die Baugruppe im Sandwich-Aufbau oberhalb der Ebene des Kondensators und des Leistungsmoduls befindet, während sich der Wasserkühler unterhalb der Ebene des Kondensators und Leistungsmoduls befindet.

Der erfindungsgemäße Sandwich-Aufbau und die erfindungsgemäße flache Anordnung des Wechselrichters führen zu einem vorteilhaften thermischen Design, in dem die Komponenten des Wechselrichters nach Kühlbedarf partitioniert werden. Leiterplattengebundene Bauelemente und Elemente mit geringem Kühlbedarf sind an eine passive Wärmesenke angebunden. Die Funktion dieser passiven Wärmesenke beschränkt sich auf Wärmeverteilung und Wärmeleitung an das Gehäuse. Die Verlustleistung aus der Treiberschaltung und dem Controller sowie die Verlustleistung aus den Stromleitungen werden direkt an die passive Wärmesenke abgegeben. Die von der passiven Wärmesenke aufgenommene Wärme wird über deren Randbereiche und über das Metallgehäuse abgeführt. Komponenten mit erheblichem Kühlbedarf, wie z.B. die Halbleiterschalter, sind dagegen an eine aktive Kühlstruktur, z.B. an einen Wasserkühler angebunden. Die aktive Kühlung ermöglicht die Abfühlung von Verlustleistung über ein fluides Kühlmedium. Zu den Komponenten mit erheblichem Kühlbedarf zählen die Leistungsmodule und der Kondensator. Diese Komponenten können durch die erfindungsgemäße Anordnung des Wechselrichters optimal thermisch integriert werden.

Der erfindungsgemäße Sandwich-Aufbau und die erfindungsgemäße flache Anordnung des Wechselrichters führen weiterhin zu einem vorteilhaften elektromagnetischen Design, wobei der Controller und die Treiberschaltung durch eine Metallplatte (Wärmesenke) und durch das Gehäuse des Wechselrichters elektromagnetisch vom Kondensator und vom Leistungsmodul abgekoppelt sind. Die Ströme durch die Leistungsmodule zu den Kondensatoren, zur Batterie und zur elektrischen Maschine erzeugen ein starkes elektromagnetisches Feld. Die genannten elektromagnetischen Felder sind durch die Wärmesenke und das Gehäuse von den Leistungstreibern und dem Controller abgeschirmt. Die empfindlichen Gate-Ansteuersignale des Treibers werden auf kürzestem Wege durch kleine Öffnungen in der Metallplatte (Wärmesenke) an das Leistungsmodul geführt.

Der erfindungsgemäße Sandwich-Aufbau und die erfindungsgemäße flache Anordnung des Wechselrichters führen des weiteren zu einem vorteilhaften mechanischen Design. Gemäß der vorliegenden Erfindung erfolgt eine planare Anordnung der elektrischen Verbindung zwischen Leistungsmodulen und Kondensatoren und/oder Leistungsmodulen und Batterie in einer Ebene parallel zur Kühlplatte (Wärmesenke). Somit können die erwähnten elektrischen Verbindungen, die Kühlplatte sowie Treiberschaltung und Controller in einem flachen Sandwich übereinanderliegen. Diese Kompaktheit des Sandwich-Aufbaus spart in der Endmontage nötigen Arbeitsaufwand, da im wesentlichen nur eine Komponente im Gehäuse montiert werden muß. Vorteilhafterweise können die genannten Module, die Kühlplatte und die genannten elektrischen Verbindungen durch elektrisch isolierende, aber thermisch leitfähige Elemente miteinander verbunden werden. Derartige großflächige Verbindung bringt sich mit einer vibrationsfesten Anordnung mit höheren mechanischen Steifigkeit und Schwingungsfestigkeit, mit einer besseren Wärmeabfuhr über die Kühlplatte sowie mit der Möglichkeit, Treiberschaltung und Controller in nächster Nähe der Leistungsmodule zu platzieren.

Bevorzugte Ausgestaltungen der Erfindung ergeben sich aus den sich an den Anspruch 1 sowie an den Anspruch 17 anschließenden Unteransprüchen.

Vorteilhaft ist die Wärmesenke eine passive Wärmesenke, z.B. eine Kühlplatte. Leistungstreiber bzw. Treiberschaltung und Controller sind über gut wärmeleitende Verbindung mit der Kühlplatte verbunden, so dass die Verlustleistung als Wärme in die Kühlplatte geführt wird.

Die Kühlplatte kann beispielsweise aus einem thermisch gut leitenden Material bestehen und aufgrund ihrer Dicke und Materialdaten eine hohe Steifigkeit aufweisen.

Idealerweise ist die Kühlplatte aus Metall gefertigt, so dass sie bezüglich elektromagnetischer Felder eine Schirmwirkung besitzt. Die elektromagnetische Schirmung der sich zwischen Gehäuseteil und Kühlplatte befindlichen Elemente wird durch leitfähige Verbindungselemente zwischen Gehäuseteil und Kühlplatte hergestellt.

In einer besonderen Ausgestaltung befindet die Wärmesenke sich zwischen einer ersten Leiterplatte und einer zweiten Leiterplatte.

Die mindestens eine Treiberschaltung und der mindestens eine Controller sind vorteilhaft auf der ersten Leiterplatte integriert. Somit können mehrere Steckverbinder entfallen, was zu einer erhöhten Zuverlässigkeit des Gesamtsystems führt.

In einer besonderen Ausgestaltung sind die erste Leiterplatte und/oder die zweite Leiterplatte thermisch und mechanisch eng mit der Wärmesenke verbunden. Somit wird die erste Leiterplatte mit der Treiberschaltung und dem Controller gut gekühlt. Die in der zweiten Leiterplatte auftretende Verlustleistung kann auch leicht über die Wärmesenke bzw. Kühlplatte und das Gehäuse oder Gehäuseteil des Wechselrichters an die Umgebung abgeführt werden. Ein weiterer Vorteil dieses Aufbaus besteht darin, dass die mechanische Belastung der ersten Leiterplatte sowie die Belastung der elektrischen Verbindung und Kontakte an der zweiten Leiterplatte unter dem Einfluß von Schwingungen minimiert werden können.

Die erste Leiterplatte und/oder die zweite Leiterplatte können vorteilhafterweise mittels einer Klebefolie mit der Wärmesenke bzw. Kühlplatte verbunden werden.

In einer anderen Ausgestaltung der Erfindung werden die ersten Leiterplatte und/oder die zweite Leiterplatte durch Nieten oder Schrauben mit der Wärmesenke verbunden.

Besonders vorteilhaft ist es, die Führung der von hohen Strömen durchflossenen elektrischen Leiterzüge zwischen den Leistungsmodulen, den Kondensatoren und der Batterie zumindest teilweise auf der zweiten Leiterplatte anzuordnen. Ein Vorteil besteht darin, dass zum einen die Leiterzüge auf der zweiten Leiterplatte kostengünstig herzustellen und zu montieren sind. Ein weiterer Vorteil besteht darin, dass aufgrund der geometrisch festgelegten elektrischen Kontakte und Verbindungen auf der zweiten Leiterplatte Fehlverkabelungen vermieden werden und parasitäre Kapazitäten und Induktivitäten nicht so hohen Exemplarstreuungen unterworfen sind.

Vorteilhafterweise kann die zweite Leiterplatte im Mehrschichtaufbau (Multilayer) ausgeführt werden. Damit können Hin- und Rückleiter der Gleichstromverbindungen auf den dicht übereinander liegenden Flächen der zweiten Leiterplatte angeordnet sein. Diese Anordnung minimiert die Induktivitätsbeläge der Verbindungen. Daraus folgt, dass beim Schalten weniger Überspannung entsteht. Somit kann die Kapazität des Zwischenkreiskondensators hinsichtlich Ripplespannungen geringer ausgelegt werden.

Vorteilhafterweise existiert mindestens eine Bohrung oder Ausfräsung in der Wärmesenke und in der ersten Leiterplatte und/oder der zweiten Leiterplatte zum Anbringen von bedrahteten Bausteinen auf den Leiterplatten, um Kurzschlüsse von Anschlüssen dieser Bausteine mit der Kühlplatte bzw. Wärmesenke zu vermeiden.

In einer weiteren Ausgestaltung der Erfindung wird die Kühlplatte bzw. Wärmesenke direkt in der ersten Leiterplatte integriert, wie es bei sogenannten Metallkernleiterplatten üblich ist.

Vorteilhaft ist die Kühlplatte bzw. Wärmesenke dort nicht von den Leiterplatten überdeckt, wo sie mechanisch, thermisch und elektrisch mit dem Gehäuseteil verbunden werden kann. Der Vorteil liegt in der besseren Wärmeableitung.

In der erfindungsgemäßen Anordnung des Wechselrichters ist das Gehäuse oder Gehäuseteil in idealer Weise aus Metall und kann als Sinterteil, als Gußteil, als Frästeil oder Blechbiegeteil ausgebildet sein. Vorteilhaft ist das Gehäuse oder Gehäuseteil aus einem Metall mit hoher elektrischer und thermischer Leitfähigkeit gefertigt. In einer anderen erfindungsgemäßen Ausführungsform wird das Gehäuseteil aus einem keramischen oder polymeren Material oder einem Verbundwerkstoff mit Glas- oder Kohlefasern ausgeformt und - sofern das Material selber nicht elektrisch leitfähig ist - das Material mit einem elektrisch leitfähigen Überzug zu versehen, beispielsweise mit einem galvanisch abgeschiedenen Metall. Das Gehäuse oder Gehäuseteil kann zum Beispiel als Gehäusedeckel ausgebildet sein.

Vorteilhaft ist die Kühlplatte bzw. Wärmesenke über gut wärmeleitende Verbindung mechanisch, thermisch und elektrisch mit dem Gehäuse oder Gehäuseteil verbunden, so dass die Verlustwärme von Leistungstreiber und Controller leicht in das Gehäuseteil abgeführt werden kann. Eine Ausführungsform der Erfindung besteht darin, die Kühlplatte bzw. Wärmesenke über Schraubverbindungen mit dem Gehäuse oder Gehäuseteil zu verbinden. Weitere Ausführungen der Erfindung nutzen Klebe-, Schweiß-, Niet- oder Klemmverbindungen.

Vorteilhafterweise ist die Kühlplatte bzw. Wärmesenke mit mindestens einer Öffnung versehen, so dass die Kontakte des Leistungsmoduls zum Ansteuern des Leistungsmoduls durch die Öffnung elektrisch leitend mit der ersten Leiterplatte verbunden werden können. Somit kann die Verbindung zwischen der Treiberschaltung und den Leistungsmodulen so kurz wie möglich sein.

In einer weiteren Ausgestaltung der Wechselrichteranordnung wird die Kühlplatte bzw. Wärmesenke in einer dritten Leiterplatte integriert, wobei auf der vom Leistungsmodul und vom Kondensator abgewandten Seite der dritten Leiterplatte Treiberschaltung und Controller angeordnet sind, und auf der dem Leistungsmodul und dem Kondensator zugewandten Seite der dritten Leiterplatte Verbindungen zwischen dem Leistungsmodul und dem Kondensator angeordnet sind. Vorteilhaft ist die Kühlplatte bzw. Wärmesenke dort von der dritten Leiterplatte freigeschnitten, wo sie mechanisch, thermisch und elektrisch mit dem Gehäuse oder Gehäuseteil verbunden wird. Der Vorteil liegt in der besseren Wärmeableitung.

Zusammenfassend ergeben sich mit der Erfindung folgende wesentlichen Vorteile:
- Verringerung von Bauvolumen durch einen kompakten Aufbau leistungselektronischer Baugruppen. Kompakt bedeutet hier einen geringen Abstand zwischen Unterbaugruppen;
- Verringerung von Gewicht durch Erhöhung der Stromdurchflusses durch die Stromleitungen;
- Erhöhung des maximalen Stromdurchflusses durch optimierte Wärmeabführung;
- Verbesserte Integrationsfähigkeit in ein bestehendes Gehäusekonzept;
- Verbindung von Leistungselektronik-Komponenten, insbesondere Treiberschaltung, Controller und Stromleitungen zu einer kompakten mechanischen Einheit;
- Verringerung des Montageaufwands von leistungselektronischen Baugruppen;
- Vereinfachung der Montage von Leistungselektronik-Komponenten durch Zusammenfassen der Baugruppen Controller, Treiberschaltung, Stromleitungen und Wärmesenke;
- Mechanische Stabilisierung der Leiterplatte (Controller und Treiberschaltung) und Stromleitungen gegen Vibrationen;
- Direkte Ableitung von Wärme, welche durch Verlustleistung in den Bauelementen auf den Leiterplatten und in den Verbindungselementen der Stromleitungen entsteht;
- Verteilung der Wärme, welche durch Verlustleitung in Bauelementen und Verbindungselementen entsteht;
- Minimierung der Eigenerwärmung der Leistungselektronik;
- Vermeidung von Hot-Spots (überhitzten Stellen) durch kritische Bauelemente und Verbindungselemente, welche aufgrund von räumlichen Randbedingungen (Kompaktheit, zerklüfteter Bauraum) nicht optimal ausgelegt werden können;
- Widerstandsfähigkeit bei Dauerbetriebstemperaturen bis 125°C;
- Widerstandsfähigkeit bei einer hohen Anzahl von Temperaturwechseln von -40°C bis 125°C;
- EMV-Schutz der Steuerschaltung (Controller und Treiber) vor Einflüssen der Leistungsschalter im Leistungsmodul, der Stromleitungen und des Zwischenkreis-Kondensators;
- Lösung des Problems, dass sowohl Gate-Anschlüsse (Pins, Leiterplattenanschlüsse) als auch Leistungsanschlüsse (Verschraubung) an einem Leistungsmodul häufig an der Oberseite angebracht sind. Damit sind die Freiheitsgrade für eine platzsparende Unterbringung der Stromleitungen stark eingeschränkt.

Weitere Merkmale, Einzelheiten und Vorteile ergeben sich aus der folgenden anhand einer Zeichnung beschriebenen bevorzugten Ausführungsform. Es zeigen:
- Fig.1:: eine Explosionsdarstellung einer Baugruppe und einer Anordnung eines Wechselrichters gemäß der vorliegenden Erfindung;
- Fig.2:: eine Ausführungsform der Verbindung zwischen der ersten Leiterplatte und der Wärmesenke im seitlichen Querschnitt;
- Fig.3a:: eine alternative Ausführungsform der Verbindung zwischen der ersten Leiterplatte und der Wärmesenke im seitlichen Querschnitt;
- Fig.3b:: eine weitere alternative Ausführungsform der Verbindung zwischen der ersten Leiterplatte und der Wärmesenke im seitlichen Querschnitt;
- Fig.4 :: eine alternative Ausführungsform der vorliegenden Erfindung;
- Fig.5:: eine weitere alternative Ausführungsform der vorliegenden Erfindung;
- Fig.6a: eine Ausführungsform der Verbindung zwischen der ersten Leiterplatte und der Wärmesenke sowie der Verbindung zwischen der zweiten Leiterplatte und der Wärmesenke im seitlichen Querschnitt;
- Fig.6b:: eine alternative Ausführungsform der Verbindung zwischen der ersten Leiterplatte und der Wärmesenke sowie der Verbindung zwischen der zweiten Leiterplatte und der Wärmesenke im seitlichen Querschnitt und
- Fig.7:: eine weitere alternative Ausführungsform der vorliegenden Erfindung.

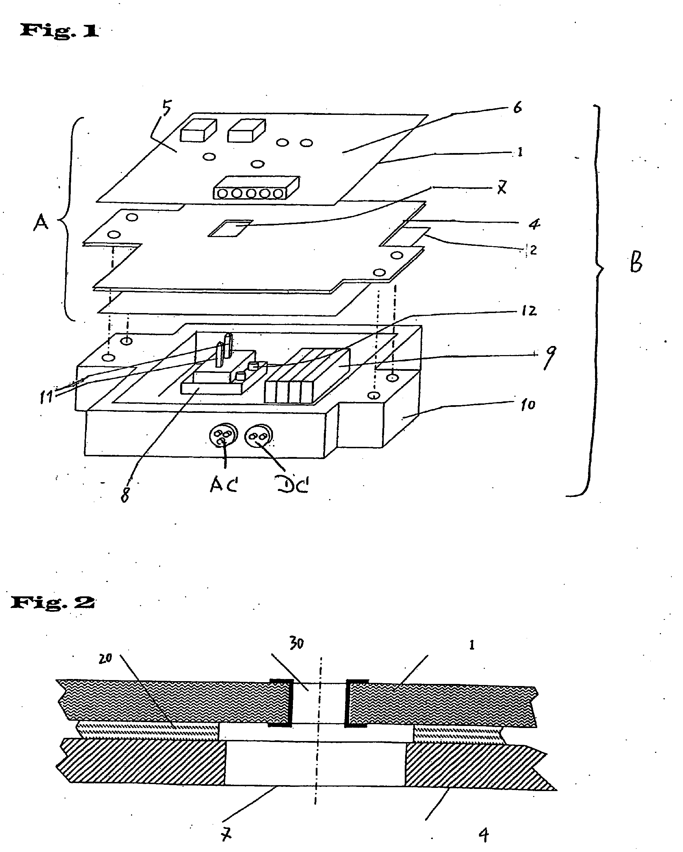

Fig.1 zeigt eine erfindungsgemäße Baugruppe im Sandwich-Aufbau mit leistungselektronischen Baugruppen A und eine erfindungsgemäße Anordnung eines Wechselrichters B vor.

Der Sandwich-Aufbau A umfaßt eine Wärmesenke bzw. Kühlplatte 4, eine erste Leiterplatte 1 und eine zweite Leiterplatte 2. Eine Treiberschaltung 5 und ein Controller 6 sind auf der ersten Leiterplatte 1 integriert. Die Kühlplatte 4 befindet sich zwischen der ersten Leiterplatte 1 und der zweiten Leiterplatte 2, wobei die Treiberschaltung 5 und der Controller 6 auf der Oberseite der Kühlplatte 4 angeordnet sind. Wie in Fig. 1 gezeigt liegen die erste Leiterplatte 1, die Kühlplatte 4 und die zweite Leiterplatte in einem flachen Sandwich übereinander.

Die Anordnung B des Wechselrichters umfaßt ein Gehäuse oder Gehäuseteil 10, einen Wasserkühler (nicht näher gezeigt), die Leistungsmodule 8 mit Kontakten 11 und Hochstromkontakte 12, die Kondensatoren 9 sowie den Sandwich-Aufbau A. In der Vertiefung innerhalb eines Teils des Gehäuseteils 10 befinden sich die Leistungsmodule 8, die Kondensatoren 9 sowie die hohe Ströme tragenden elektrischen Verbindungen zwischen den Leistungsmodulen 8 und den Kondensatoren 9. Die Leistungsmodule 8 und die Kondensatoren 9, die sich in derselben Ebene neben den Leistungsmodulen 8 befinden, können anliegend am Boden oder an den Wänden im Innern des Gehäuseteils 10 angeordnet sein. Durch mechanische und wärmeleitende Elemente (nicht näher gezeigt) werden die Leistungsmodule 8 und die Kondensatoren fixiert und ihre Verlustwärme in das Gehäuseteil 10 abgeleitet. Die mechanischen und wärmeleitenden Elemente können identisch sein.

Die Leistungsmodule 8 sind vorteilhaft in Modulen gruppierte Halbleiterschalter und Dioden mit gemeinsamen Gehäusen. Dabei können die Module die für mehrere Phasen benötigten Halbleiterschalter und Dioden enthalten.

Wie in Fig.1 gezeigt ist der Sandwich-Aufbau A Teil dieser übergeordneten Anordnung. Die vorteilhafte Ausbildung des Wechselrichters besteht darin, dass Leistungstreiber bzw. Treiberschaltung 5 und Controller 6 sich auf der den Leistungsmodule 8 und Kondensatoren 9 abgewandten Seite der Kühlplatte 4 befinden, welche die Leistungsmodule 8 und Kondensatoren 9 im Gehäuseteil 10 einschließt. Die Kondensatorelemente 9 befinden sich neben den Leistungsmodulen 8 in derselben Ebene innerhalb des Gehäuseteils 10. Die elektrischen Verbindungen zwischen den Hochstromkontakten 12 der Leistungsmodule 8 und den Kondensatoren 9 sowie die elektrischen Verbindungen zu den elektrischen Kontakten AC des elektronischen Wechselrichters zur elektronischen Maschine sowie den elektrischen Kontakten DC des elektronischen Wechselrichters zur Batterie sind unterhalb der Kühlplatte 4 geführt. Diese elektrischen Verbindungen sind jeweils von hohen Strömen durchflossen. Unterhalb der Leistungsmodule 8 und der Kondensatorelemente 9 befindet sich eine aktive Kühlstruktur, z.B. Wasserkühler (nicht näher gezeigt).

Die flache Wechselrichteranordnung partitioniert, d.h. unterteilt die Komponente des Wechselrichters nach Kühlbedarf, wobei die Treiberschaltung 5 und der Controller 6 mit geringem Kühlbedarf an die passive Wärmesenke bzw. Kühlplatte 4 verbunden sind, während die Leistungsmodule 8 und die Kondensatoren 9 mit erheblichen Kühlbedarf an eine aktive Wasserkühler angebunden sind. Die Treiberschaltung 5 und der Controller 6 werden mittels der Kühlplatte 4 und des Gehäuseteils 10 gegen die von den Leistungsmodule 8 und den Kondensatoren 9 erzeugten elektromagnetischen Felder abgeschirmt.

Fig.2 zeigt eine Ausführungsform über die Verbindung zwischen der ersten Leiterplatte 1 und der Wärmesenke 4 im seitlichen Querschnitt. Dazu wird die erste Leiterplatte mittels einer Klebefolie 20 mit der Wärmesenke verbunden. Die erste Leiterplatte können unter Druck und Temperatur mittels der Klebefolie auf die Kühlplatte 4 laminiert. Vorteilhaft kann hier eine gut wärmeleitende und/oder dünne Klebefolie verwendet werden, um den Wärmeübergang von der ersten Leiterplatte 1 auf die Kühlplatte 4 durch diese Klebefolie zu erleichtern. Vorteilhaft kann weiterhin eine elektrisch isolierende Klebefolie verwendet werden, um Kurzschlüsse von Leiterbahnen 15 auf der Leiterplatte 1 zur Kühlplatte 4 zu vermeiden. Der Laminiervorgang erfolgt vorzugsweise vor dem Bestücken und Löten der ersten Leiterplatte 1.

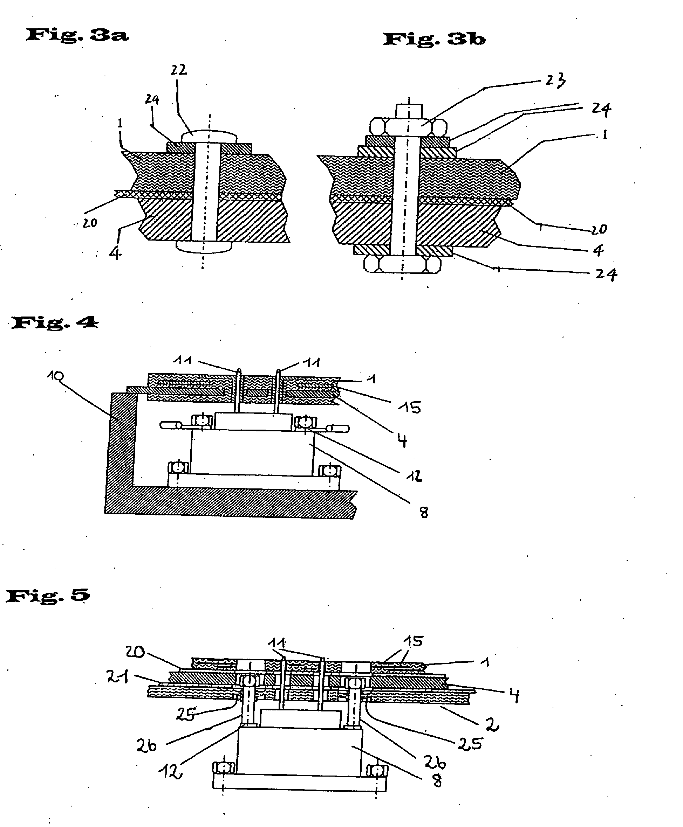

In einer anderen Ausgestaltung der Erfindung werden die Wärmesenke bzw. Kühlplatte 4 und die erste Leiterplatte 1 durch Nieten gemäß Fig.3a oder Schrauben gemäß Fig.3b miteinander verbunden. Die Nieten und Schrauben werden durch mechanische Elemente 24 gesichert. Das vermeidet, dass die Verbindungen sich dadurch lockern oder dass die erste Leiterplatte sich im Laufe der Zeit plastisch verformt. Zwischen der ersten Leiterplatte 1 und der Kühlplatte 4 wird auch eine elektrisch isolierende Klebefolie 20 angeordnet. Der Vorteil liegt in der erhöhten elektrischen Spannungsfestigkeit der Anordnung (elektrisches Potential der Kühlplatte 4 gegen elektrisches Potential der Leiterbahnen 15 der ersten Leiterplatte 1).

Fig. 4 zeigt eine weitere Ausführungsform der erfindungsgemäßen Wechselrichteranordnung. Hier wird die Kühlplatte 4 direkt in der ersten Leiterplatte 1 integriert, wie es bei sogenannten Metallkernleiterplatten üblich ist. Der Metallkern 4 zur Ableitung der Wärme an das Gehäuseteil 10 liegt ebenso in der Leiterplatte 1 wie die elektrischen Leiterbahnen 15. Der Metallkern 4 ist dort von der restlichen Leiterplatte 1 freigestellt, wo er mechanisch, thermisch und elektrisch mit dem Gehäuseteil 10 verbunden wird, so dass die Wärme besser abgeleitet werden kann.

In einer Ausführungsform gemäß Fig.5 sind die erste Leiterplatte 1 oberhalb der Kühlplatte 4 und die zweite Leiterplatte 2 unterhalb der Kühlplatte 4 angeordnet. Sie sind thermisch und mechanisch mit der Kühlplatte 4 verbunden. Wie in Fig.5 gezeigt wird die zweite Leiterplatte 2 mittels einer Klebefolie 21 an die Kühlplatte 4 geklebt, während die Leiterplatte 1 mittels einer Klebefolie 20 mit der Kühlplatte 4 verbunden ist. Vorteilhaft ist die Verwendung einer dünnen und/oder gut wärmeleitenden Klebefolien 20 und 21, um den Wärmeübergang zwischen der ersten Leiterplatte 1 und Kühlplatte 4 sowie zwischen der zweiten Leiterplatte 2 und Kühlplatte 4 zu erleichtern. Vorteilhaft ist weiterhin die Verwendung der elektrisch isolierenden Klebefolien 20 und 21, um Kurzschlüsse von Leiterbahnen 15 auf der Leiterplatte 1 sowie der Leiterplatte 2 zur Kühlplatte 4 zu vermeiden.

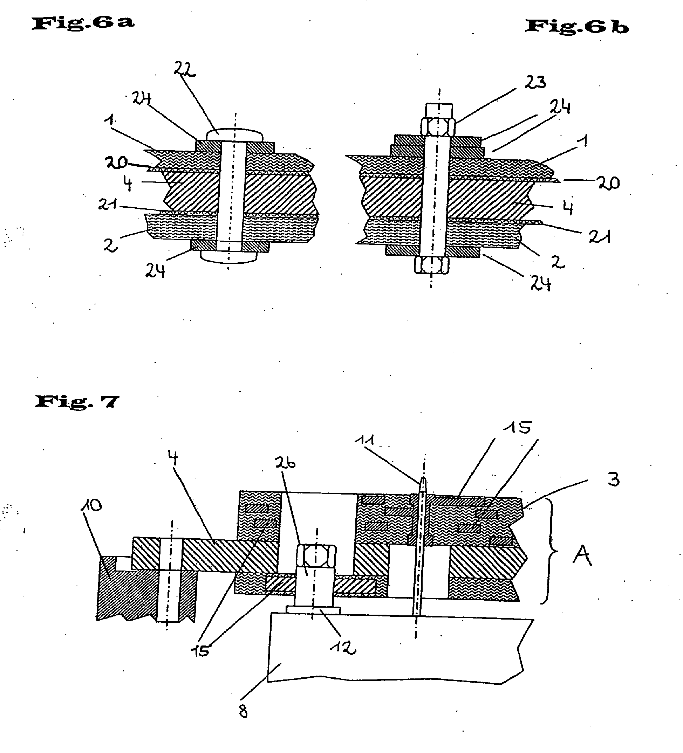

In einer weiteren Ausführungsform gemäß Fig. 6a und Fig.6b wird die zweite Leiterplatte 2 durch Nieten oder Schrauben mit der Kühlplatte 4 verbunden. Vorteilhaft werden die erste Leiterplatte 1, die Kühlplatte 4 und die zweite Leiterplatte 2 in einem Arbeitsgang durch die Nieten oder Schrauben miteinander verbunden. Zwischen der ersten Leiterplatte 1 und der Kühlplatte 4 wird eine elektrisch isolierende Klebefolie 20 angeordnet und zwischen der Kühlplatte 4 und der zweiten Leiterplatte 2 wird eine elektrisch isolierende Klebefolie 21 angeordnet. Der Vorteil liegt in der erhöhten elektrischen Spannungsfestigkeit der Anordnung (elektrisches Potential der Kühlplatte 4 gegen elektrisches Potential der Leiterbahnen 15 der ersten Leiterplatte 1 und der zweiten Leiterplatte 2).

Auf der zweiten Leiterplatte 2 sind die elektrischen Leiterzüge zwischen den Leistungsmodulen 8, den Kondensatoren 9 und der Batterie zumindest teilweise ausgeführt. Wie in Fig. 5 gezeigt, erfolgt die elektrische Verbindung der Leistungsmodule 8 mit der zweiten Leiterplatte 2 vorteilhaft über Einpresselemente 26. Teile der zweiten Leiterplatte 2 sind als flexible Elemente 25 ausgebildet, um Höhentoleranzen von Gehäuseteil 10, Leiterplatte 2, Einpresselementen 26 und Leistungsmodulen 8 auszugleichen.

Wie in Fig.1 und Fig. 2 gezeigt existieren Bohrung 30 in der ersten Leiterplatte 1 und Öffnungen 7 in der Kühlplatte 4 zum Anbringen von bedrahteten Bausteinen in der ersten Leiterplatte 1 zur Vermeidung von Kurzschlüssen von Anschlüssen dieser Bausteine mit der Kühlplatte 4. Die Kontakte 11 der Leistungsmodule zur Ansteuern der Leistungsmodule gehen durch die Öffnung 7 in der Kühlplatte 4 und werden in der Bohrung 30 in der ersten Leiterplatte 1 elektrisch mit dieser verbunden, siehe Fig.5. Die elektrische Verbindung wird vorteilhafterweise als Lötverbindung oder Einpressverbindung ausgeführt.

Fig. 7 zeigt eine weitere alternative Ausführungsform der Erfindung. Die Kühlplatte 4 wird in einer dritten Leiterplatte 3 integriert. Diese Leiterplatte 3 trägt auf der von den Leistungsmodulen und Kondensatoren abgewandten Seite Controller und Leistungstreiber (nicht näher gezeigt). Auf der den Leistungsmodulen und Kondensatoren zugewandten Seite der Leiterplatte 3 sind die Verbindungen zwischen Leistungsmodulen und Kondensatoren angeordnet. Der Metallkern 4 ist dort von der restlichen Leiterplatte 3 freigeschnitten, wo er mechanisch, thermisch und elektrisch mit dem Gehäuseteil 10 verbunden wird.

## Patentansprüche

1. Leistungselektronische Baugruppe mit mindestens einer Treiberschaltung (5) mindestens einem Controller (6), einer Wärmesenke (4), sowie Stromverbindungen (2),
**dadurch gekennzeichnet,**
**dass** die Treiberschaltung und der Controller auf der Oberseite der Wärmesenke und die Stromverbindungen auf der Unterseite der Wärmesenke angeordnet sind.

2. Baugruppe nach Anspruch 1, **dadurch gekennzeichnet, dass** die Wärmesenke eine passive Wärmesenke, z.B. eine Kühlplatte ist.

3. Baugruppe nach Anspruch 2, **dadurch gekennzeichnet, dass** die Kühlplatte aus einem thermisch gut leitenden Material mit einer hohen Steifigkeit besteht.

4. Baugruppe nach Anspruch 2, **dadurch gekennzeichnet, dass** die Kühlplatte aus Metall gefertigt ist, so dass sie eine Schirmwirkung besitzt.

5. Baugruppe nach einem der vorherigen Ansprüche, **dadurch gekennzeichnet, dass** die Wärmesenke sich zwischen einer ersten Leiterplatte und einer zweiten Leiterplatte befindet, wobei die Treiberschaltung und der Controller vorzugsweise auf der ersten Leiterplatte integriert sind und wobei die erste Leiterplatte und/oder die zweite Leiterplatte besonders vorzugsweise thermisch und mechanisch mit der Wärmesenke verbunden ist.

6. Baugruppe nach Anspruch 5, **dadurch gekennzeichnet, dass** die erste Leiterplatte und/oder die zweite Leiterplatte mittels einer Klebefolie mit der Wärmesenke verbunden ist und/oder dass die erste Leiterplatte und/oder die zweite Leiterplatte durch Nieten oder Schrauben mit der Wärmesenke verbunden ist, wobei vorzugsweise elektrische Leiter zur Leistungsübertragung zumindest teilweise in der zweiten Leiterplatte integriert sind, wobei besonders vorzugsweise die zweite Leiterplatte als Multilayer ausgeführt ist und wobei ganz besonders vorzugsweise die erste Leiterplatte und/oder die zweite Leiterplatte mindestens eine Bohrung oder Ausfräsung aufweist.

7. Baugruppe nach einem der vorherigen Ansprüche, **dadurch gekennzeichnet, dass** die Wärmesenke mit mindestens einer Öffnung versehen ist, wobei vorzugsweise die Wärmesenke direkt in der ersten Leiterplatte integriert wird, wobei besonders vorzugsweise die Wärmesenke sowie beide Leiterplatten von einer dritten Leiterplatte mit integrierter Wärmesenke ersetzt werden und wobei ganz besonders vorzugsweise mindestens ein Teil der Wärmesenke von den Leiterplatten freigestellt ist.

8. Wechselrichter mit einem Gehäuse oder Gehäuseteil, einem Wasserkühler, mindestens einem Leistungsmodul, mindestens einem Kondensator, sowie einer Baugruppe nach einem der Ansprüche 1 bis 7, bei dem der Kondensator sich in einer Ebene neben dem Leistungsmodul innerhalb des Gehäuses oder Gehäuseteils befindet, wobei die vorgenannte Baugruppe sich oberhalb der Ebene des Kondensators und Leistungsmoduls befindet, und wobei der Wasserkühler sich unterhalb der Ebene des Kondensators und Leistungsmoduls befindet.

9. Anordnung nach Anspruch 8, **dadurch gekennzeichnet, dass** das Gehäuse oder Gehäuseteil aus Metall in Form eines Sinterteils, Gussteils, Frästeils oder Blechbiegeteils ausgebildet ist.

10. Anordnung nach Anspruch 9, **dadurch gekennzeichnet, dass** das Gehäuse oder Gehäuseteil aus einem keramischen oder polymeren Material oder einem Verbundwerkstoff mit Glas- oder Kohlefasern gefertigt ist, wobei das Material oder der Verbundwerkstoff mit einem elektrisch leitfähigen Überzug versehen ist.

11. Anordnung nach einem der Ansprüche 8 bis 10, **dadurch gekennzeichnet, dass** die Wärmesenke mechanisch, thermisch und elektrisch mit dem Gehäuse oder Gehäuseteil verbunden ist.

12. Anordnung nach einem der Ansprüche 8 bis 11, **dadurch gekennzeichnet, dass** die Wärmesenke mit mindestens einer Öffnung versehen ist, so dass mindestens ein Kontakt des Leistungsmoduls zum Ansteuern des Leistungsmoduls durch die Öffnung elektrisch leitend mit der ersten Leiterplatte verbunden ist.

13. Anordnung nach einem der Ansprüche 8 bis 12, **dadurch gekennzeichnet, dass** die Wärmesenke in einer dritten Leiterplatte integriert ist, wobei auf der vom Leistungsmodul und Kondensator abgewandten Seite der dritten Leiterplatte die Treiberschaltung und der Controller angeordnet sind und wobei auf der dem Leistungsmodul und Kondensator zugewandten Seite der dritten Leiterplatte Verbindungen zwischen dem Leistungsmodul und dem Kondensator angeordnet sind.

14. Anordnung nach Anspruch 13, **dadurch gekennzeichnet, dass** die Wärmesenke dort von der dritten Leiterplatte freigestellt ist, wo sie mechanisch, thermisch und elektrisch mit dem Gehäuse oder Gehäuseteil verbunden ist.

## Claims

1. A power electronic assembly comprising at least one driver circuit (5), at least one controller (6), a heat sink (4) and power connections (2),
**characterized in that**
the driver circuit and the controller are arranged on the upper side of the heat sink and the power connections are arranged on the lower side of the heat sink.

2. An assembly in accordance with claim 1, **characterized in that** the heat sink is a passive heat sink, e.g. a cooling plate.

3. An assembly in accordance with claim 2, **characterized in that** the cooling plate comprises a thermally easily conductive material with a high stiffness.

4. An assembly in accordance with claim 2, **characterized in that** the cooling plate is produced from metal so that it has a shield effect.

5. An assembly in accordance with one of the preceding claims, **characterized in that** the heat sink is located between a first circuit board and a second circuit board, wherein the driver circuit and the controller are preferably integrated on the first circuit board, and wherein the first circuit board and/or the second circuit board is/are particularly preferably thermally and mechanically connected to the heat sink.

6. An assembly in accordance with claim 5, **characterized in that** the first circuit board and/or the second circuit board is/are connected to the heat sink by means of an adhesive film; and/or **in that** the first circuit board and/or the second circuit board is/are connected to the heat sink by rivets or screws, wherein electrical conductors for power transfer are preferably at least partially integrated in the second circuit board, wherein the second circuit board is particularly preferably configured as a multilayer, and wherein the first circuit board and/or the second circuit board very particularly preferably has/have at least one bore or cut-out.

7. An assembly in accordance with one of the preceding claims, **characterized in that** the heat sink is provided with at least one opening, wherein the heat sink is preferably directly integrated in the first circuit board, wherein the heat sink as well as both circuit boards are particularly preferably replaced with a third circuit board having an integrated heat sink, and wherein at least one part of the heat sink is very particularly preferably liberated from the circuit boards.

8. An inverter comprising a housing or a housing part, a water cooler, at least one power module, at least one capacitor, as well as an assembly in accordance with one of the claims 1 to 7, wherein the capacitor is located in a plane beside the power module within the housing or housing part, wherein the aforesaid assembly is located above the plane of the capacitor and of the power module, and wherein the water cooler is located beneath the plane of the capacitor and of the power module.

9. An arrangement in accordance with claim 8, **characterized in that** the housing or housing part is formed from metal in the form of a sintered part, a cast part, a milled part or a flexible sheet metal part.

10. An arrangement in accordance with claim 9, **characterized in that** the housing or housing part is produced from a ceramic or polymer material or from a composite material having glass fibers or carbon fibers wherein the material or composite material is provided with an electrically conductive cover.

11. An arrangement in accordance with one of the claims 8 to 10, **characterized in that** the heat sink is mechanically, thermally and electrically connected to the housing or housing part.

12. An arrangement in accordance with one of the claims 8 to 11, **characterized in that** the heat sink is provided with at least one opening so that at least one contact of the power module for controlling the power module is connected electrically conductively to the first circuit board through the opening.

13. An arrangement in accordance with one of the claims 8 to 12, **characterized in that** the heat sink is integrated in a third circuit board, wherein the driver circuit and the controller are arranged on the side of the third circuit board remote from the power module and from the capacitor, and wherein connections between the power module and the capacitor are arranged on the side of the third circuit board facing the power module and the capacitor.

14. An arrangement in accordance with claim 13, **characterized in that** the heat sink is liberated from the third circuit board where it is mechanically, thermally and electrically connected to the housing or to the housing part.

## Revendications

1. Module électronique de puissance comprenant au moins un circuit d'excitation (5), au moins un contrôleur (6), un dissipateur thermique (4), ainsi que des liaisons électriques (2),
**caractérisé en ce que**
le circuit d'excitation et le contrôleur sont disposés sur la face supérieure du dissipateur thermique et les liaisons électriques sur la face inférieure du dissipateur thermique.

2. Module selon la revendication 1, **caractérisé en ce que** le dissipateur thermique est un dissipateur thermique passif, par exemple une plaque de refroidissement.

3. Module selon la revendication 2, **caractérisé en ce que** la plaque de refroidissement est constituée d'un matériau à bonne conduction thermique avec une rigidité élevée.

4. Module selon la revendication 2, **caractérisé en ce que** la plaque de refroidissement est fabriquée en métal, de sorte qu'elle possède un effet de blindage.

5. Module selon l'une des revendications précédentes, **caractérisé en ce que** le dissipateur thermique se trouve entre une première carte de circuit imprimé et une seconde carte de circuit imprimé, le circuit d'excitation et le contrôleur étant de préférence intégrés sur la première carte de circuit imprimé, et la première carte de circuit imprimé et/ou la seconde carte de circuit imprimé étant reliée(s) plus préférentiellement thermiquement et mécaniquement au dissipateur thermique.

6. Module-selon la revendication 5, **caractérisé en ce que** la première carte de circuit imprimé et/ou la seconde carte de circuit imprimé est/sont reliée(s) au dissipateur thermique au moyen d'une feuille de collage et/ou **en ce que** la première carte de circuit imprimé et/ou la seconde carte de circuit imprimé est/sont reliée(s) au dissipateur thermique par des rivets ou des vis, des conducteurs électriques étant intégrés de préférence au moins partiellement dans la seconde carte de circuit imprimé pour le transfert de puissance, la seconde carte de circuit imprimé étant plus préférentiellement exécutée sous la forme d'une carte multicouche et la première carte de circuit imprimé et/ou la seconde carte de circuit imprimé comportant idéalement un trou ou une fraisure.

7. Module selon l'une des revendications précédentes, **caractérisé en ce que** le dissipateur thermique est doté d'au moins un orifice, le dissipateur thermique étant de préférence intégré directement dans la première carte de circuit imprimé, le dissipateur thermique ainsi que les deux cartes de circuit imprimé étant plus préférentiellement remplacés par une troisième carte de circuit imprimé avec dissipateur thermique intégré, et au moins une partie du dissipateur thermique étant idéalement exempte des cartes de circuit imprimé.

8. Onduleur comprenant un boîtier ou une partie de boîtier, un refroidisseur à eau, au moins un module de puissance, au moins un condensateur, ainsi qu'un module selon l'une des revendications 1 à 7, dans lequel le condensateur se trouve à un niveau à côté du module de puissance à l'intérieur du boîtier ou de la partie de boîtier, ledit module se trouvant au-dessus du niveau du condensateur et du module de puissance, et le refroidisseur à eau se trouvant en dessous du niveau du condensateur et du module de puissance.

9. Système selon la revendication 8, **caractérisé en ce que** le boîtier ou la partie de boîtier est réalisé(e) en métal sous la forme d'une pièce frittée, d'une pièce moulée, d'une pièce de fraisage ou d'une pièce de tôle pliée.

10. Système selon la revendication 9, **caractérisé en ce que** le boîtier ou la partie de boîtier est fabriqué(e) en un matériau céramique ou polymère ou en une matière composite avec des fibres de verre ou de carbone, le matériau ou la matière composite étant doté d'un revêtement électriquement conducteur.

11. Système selon l'une des revendications 8 à 10, **caractérisé en ce que** le dissipateur thermique est relié mécaniquement, thermiquement et électriquement au boîtier ou à la partie de boîtier.

12. Système selon l'une des revendications 8 à 11, **caractérisé en ce que** le dissipateur thermique est doté d'au moins un orifice, de sorte qu'au moins un contact du module de puissance est relié par l'orifice de manière électriquement conductrice à la première carte de circuit imprimé pour la commande du module de puissance.

13. Système selon l'une des revendications 8 à 12, **caractérisé en ce que** le dissipateur thermique est intégré dans une troisième carte de circuit imprimé, le circuit d'excitation et le contrôleur étant disposés sur le côté de la troisième carte de circuit imprimé opposé au module de puissance et au condensateur et des liaisons entre le module de puissance et le condensateur étant disposées sur le côté de la troisième carte de circuit imprimé faisant face au module de puissance et au condensateur.

14. Système selon la revendication 13, **caractérisé en ce que** le dissipateur thermique est exempt de la troisième carte de circuit imprimé là où il est relié mécaniquement, thermiquement et électriquement au boîtier ou à la partie de boîtier.
